Europäisches Patentamt

European Patent Office

Office européen des brevets

(19)

(11) Publication number: **0 050 449**
**B1**

(12) **EUROPEAN PATENT SPECIFICATION**

(45) Date of publication of patent specification: **18.12.85**

(21) Application number: **81304671.1**

(22) Date of filing: **08.10.81**

(51) Int. Cl.⁴: **H 01 L 27/06, H 03 K 19/017, H 03 K 19/094, H 01 L 29/86, H 01 L 29/20**

(54) Semiconductor logic circuits.

(30) Priority: **16.10.80 GB 8033485**

(43) Date of publication of application:
**28.04.82 Bulletin 82/17**

(45) Publication of the grant of the patent:
**18.12.85 Bulletin 85/51**

(84) Designated Contracting States:
**DE FR IT NL**

(56) References cited:
**FR-A-2 449 369**

**IEEE TRANSACTIONS ON ELECTRON DEVICES, Vol. ED-27, no. 6, June 1980, New York, K. LEHOVEC et al. "Analysis of GaAs FET's for integrated logic", pages 1074-1091**
**Patent Abstracts of Japan, vol. 3, no. 40, 6 April 1979, page 109E102**
**Patent Abstracts of Japan, vol. 5, no. 3, 10 January 1981**

(73) Proprietor: **ITT INDUSTRIES INC.**
**320 Park Avenue**
**New York, NY 10022 (US)**
㊙ **FR IT NL**

(73) Proprietor: **Deutsche ITT Industries GmbH**
**Hans-Bunte-Strasse 19 Postfach 840**
**D-7800 Freiburg (DE)**
㊙ **DE**

(72) Inventor: **Mun, Joseph**
**204a Old Road**
**Old Harlow Essex CM17 OHQ (GB)**
Inventor: **Phillips, John Alexander**
**118 Cambridge Avenue**
**Gidea Park Essex RM2 6RA (GB)**

(74) Representative: **Dennis, Mark Charles et al**
**STC Patent Department Edinburgh Way**
**Harlow Essex CM20 2SH (GB)**

EP 0 050 449 B1

Courier Press, Leamington Spa, England.

## Description

This invention relates to integrated circuits and to the fabrication of such circuits.

The most commonly used semiconductor material is silicon. The technology of this material is well known and it can be used to fabricate a wide range of devices including integrated logic circuits. The speed of operation of such logic circuits is becoming an important factor as the complexity of the circuits increases. However this operating speed is limited ultimately by the carrier mobility in the semiconductor material. This mobility is of course an intrinsic property of the material itself. Attention is thus turning from silicon to those semiconductors having a higher carrier mobility. There are the compound semiconductors of which the best known example is gallium arsenide.

Since the first GaAs high speed logic integrated circuit was introduced in 1974, a number of circuit approaches and device technologies have been reported with the aim to minimizing the speed power product to a level suitable for large scale integration. In recent years, enhancement mode, normally-off MESFET logic has gained considerable attention due to its extremely low power consumption, circuit simplicity and high speed. Enhancement mode normally-off logics reported to date utilise a linear resistance pull-up load in series with the switching FET in their basic inverter/gate design, although the linear characteristic of such a load involves certain limitations on switching characteristics.

In a normally-off MESFET the thickness and the doping of the active region are tailored so that the built-in depletion of the Schottky barrier gate contact fully depletes the channel. The MESFET is switched on by the application of a positive voltage to the gate. The maximum voltage which can be applied is approximately 0.6 to 0.7V, and is limited by the forward conduction of gate diode. Since only positive voltage is required to switch the FET between the two logic states only a single rail supply is needed and the logic gates can be directly coupled which simplifies circuit design and mask layout. The low operating voltage is directly reflected in the low power consumption.

French specification No. 2449369 describes a velocited saturated device in which the current limiting element is a thin body of semiconductor defined by a groove disposed between current electrodes. The groove may be provided with a Schottky gate contact. This structure is by no means easy to make as it involves a number of critical masking and etching steps. Accurate etching of the groove, both in width and depth, presents particular problems and thus limits the utility of the device and increases the processing costs.

According to the present invention there is provided a gallium arsenide logic element having a non-linear pull-up load, said load comprising a gallium arsenide channel region disposed between first and second electrodes, the load being a two electrode device characterised in that the load comprises a planar structure formed on a mesa of active material disposed on a semi-insulating substrate, and that the saturation current of the load is determined by the spacing between the electrode and the mesa thickness.

We have found that velocity saturated pull-up loads can be fabricated in gallium arsenide compound semiconductor materials and having dimensions sufficiently small that the saturation voltage is within the operating voltage range of an associated logic device.

The velocity saturated pull-up load overcomes the disadvantage of the prior art resistive loads by providing a high speed switch that can operate at low power levels. The electrical characteristics of the device are determined by its dimensions and by the level to which the device is doped. Advantageously the pull-up load is formed by a photo-activated etching process. Said processes provide a high definition and accuracy thus ensuring a reproducibility of circuit parameters that has not hitherto been possible. Furthermore, the small physical size of the velocity pull-up load, as compared with prior art devices, makes it an ideal component for large scale integration.

The device may be seen in the fabrication of fast logic integrated circuits for application e.g. in high speed data transmission systems.

An embodiment of the invention will now be described with reference to the accompanying drawings in which:—

Figure 1 is a plan view of a logic circuit velocity saturated pull-up load;

Figure 2 is a cross-section through the plane A—A of the load of Figure 1;

Figure 3 is a schematic circuit diagram of a logic element provided with the load of Figures 1 or 2;

Figure 4 shows a typical current/voltage characteristic of the pull-up load of Figures 1 and 2; and

Figures 5 and 6 show typical switching characteristics of logic devices provided respectively with a conventional resistive pull-up load and the velocity saturated pull-up load of Figures 1 and 2.

The following description relates to semiconductor fabrication techniques with reference to gallium arsenide.

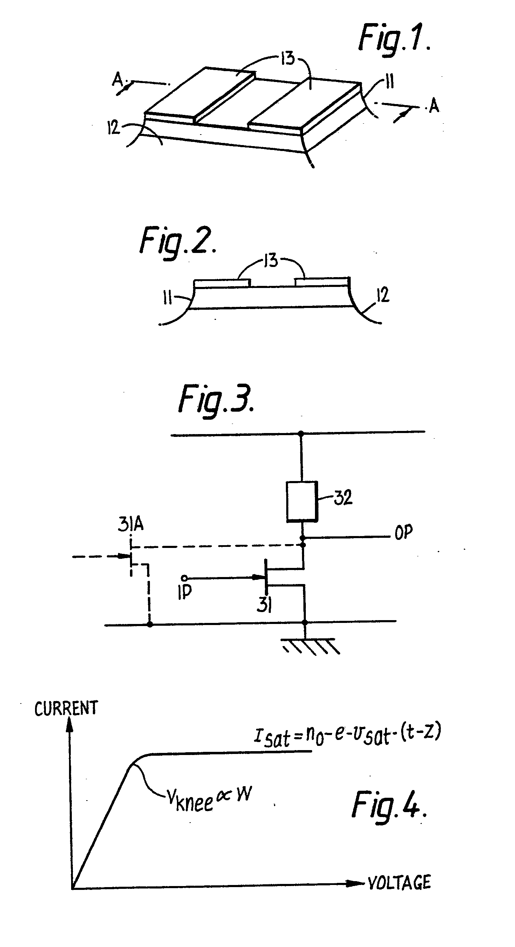

Referring now to Figures 1 and 2 the non-linear velocity saturated pull-up load comprises a substantially rectangular mesa 11 of semiconductor material disposed on a substrate 12 of either the same or an associated semiconductor material. Advantageously the mesa 11 is formed by a photo-activated anodic etching process. Typically the mesa 0.5 to 1.5 microns in height comprises a layer of material doped to 0.5 to $1.0 \times 10^{17}$/cc on an undoped buffer layer 3 microns thick. The active layer may be provided by a variety of techniques including doping, ion implantation and epitaxial growth.

The mesa 11 is provided with closely spaced electrodes 13 which may be e.g. 1 micron apart. When a voltage is applied across these electrodes a current flows therebetween, this current being limited above a critical voltage dependent on the mesa dimensions and the electrode geometry. The current is in fact limited by the carrier velocity and is thus susbtantially constant above this critical voltage.

For a non-linear pull-up load to be effective in a low voltage swing logic, the knee in the load IV characteristic has to occur at a voltage smaller than the logic swing. This can be achieved by a length of GaAs mesa with very closely spaced ohmic contacts. One micron separation, for example, will give a knee at approximately 0.5V. The power dissipation in an inverter gate is determined by the current limiting effect in the load due to electron velocity saturation in GaAs. The value of this current is primarily a function of the cross section of the mesa, and, secondly, of surface effects and substrate leakage current. A few hundred micro amps of constant current, for example, can be obtained with a mesa of a few microns wide assuming an active layer thickness of 0.12 micron doped to $0.8 \times 10^{17}/cm^3$.

Figure 3 shows a typical logic element in incorporating the velocity saturated pull-up load of Figures 1 and 2.

The logic element includes one or more field effect mode transistors 31, 31A coupled in parallel and arranged in series with a velocity saturated pull-up load 32. We prefer to employ enhancement mode transistors (MESFET's), but depletion mode transistors could also be used. When the circuit input, IP, is low (i.e. logic 0) the MESFET 31 (31A) is off and the circuit output OP is high (i.e. logic 1). If the circuit input now goes high (i.e. logic 1) the MESFET 31 (31A) turns on causing the output signal at (OP) to go low (i.e. logic 0). Because the load 32 is velocity saturated during the switching process the speed of switching is enhanced compared to that of a circuit employing a conventional resistive load where the switching time is limited by the saturation of the transistor.

Figure 4 shows a typical experimentally obtained IV characteristic of a normally-off MESFET with resistive and velocity saturation load lines in an inverter gate arrangement. Computer simulation of such normally-off inverter circuits with both linear and the present non-linear pull-up loads indicate that up to 40% increase in switching speed can be obtained with the latter. The primary effect of replacing a resistive with a velocity saturation pull-up load is the improvement in gain of the logic gate at its switching point. This occurs as the result of a significantly lower output conductance at the drain of the FET together with a higher current drive capability from the load. Apart from the improvement in propagation delay, a significant property of this load is the ability of maintaining a good noise margin for quasi normally-off FETs, i.e. FETs which require small negative voltages to fully pinch-off, making it more tolerant to processing variations.

An additional feature of this non-linear velocity saturated load is its extremely small size which makes it an ideal component for large scale integration. The use of small mesa surface area but relatively thick active layer also minimises surface effects compared with a larger resistive load. Compared with depletion mode FET loads commonly used in normally-on logic, it has the additional advantage of a smaller parasitic node capacitance.

Inverter, NOR, NAND and R/S latch gates in normally-off logic using both types of pull-up loads have been fabricated and results compared. In each type of load, six resistor values and six current limit values have been examined. All current limit pull-up loads had 1 micron ohmic contact spacing. The MESFET geometry was of 1.5 micron gate length in 4.5 micron source drain spacing. All FETs had 50 micron gate width. The material used was vapour phase epitaxial GaAs grown by the $AsCl_3$ process. The grown material had an active layer 0.12 micron thick, doped to 0.8 to $1.0 \times 10^{17}/cc$ and grown on an undoped buffer layer, nominally 3 micron thick. To reduce the active channel region to normally-off thickness, only material under the gate was removed. The pull-up loads were therefore fabricated on as-grown material. A light stimulated anodic oxidation/etch process was used to accurately remove a known amount of active material. The oxidation/etch process has a further advantageous self-limiting property in that the thickness of material left in the channel after the etch is determined by the amount of light used during the oxidation process. A calibration chart can thus be made by plotting the light intensity against pinch-off voltages of MESFETs so obtained. Repeatability of the process is obtained by careful control of light intensity for a given required pinch-off voltage, in this case zero volts.

Normally-off MESFETS with a recessed gate structure made by this process have high transconductances, typically 35 mmho/mm, compared to 20 mmho/mm from uniformly thinned material. This is due to the reduction of parasitic series gate to ohmic resistances. The self limiting property of the anodic oxidation/etch process helps to improve the uniformity in pinch-off voltage across a slice. Typical standard deviation in pinch-off voltage is 90 mV for slices approximately 2 cm square, with the best slice giving 60 mV, which is comparable to data for ion implanted material.

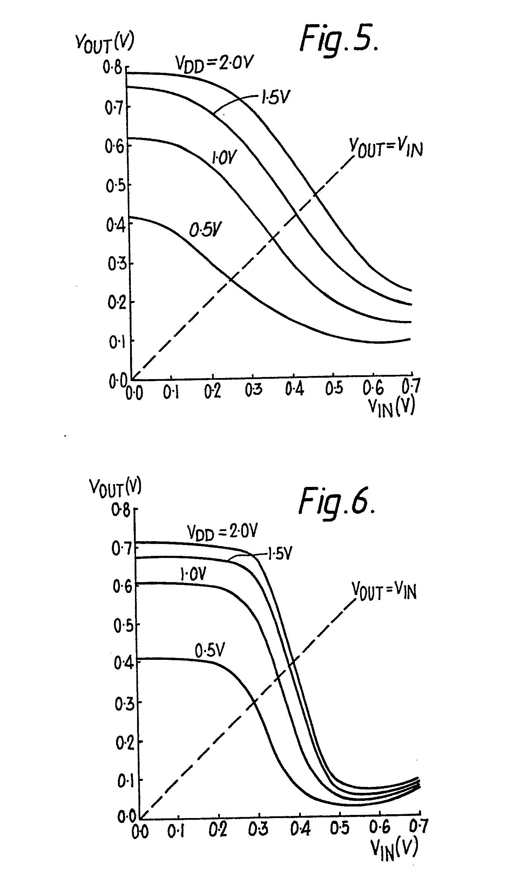

Comparison of typical transfer characteristics measured from the inverter gates using two types of pull-up loads is illustrated in Figures 5 and 6. The resistor pull-up in Figure 5 is 13 kΩ which is the optimum value for the particular FET geometry used. Smaller load values generally give smaller gains at the switching points and less noise margin. Higher load values give slightly higher gains, but require higher rail voltages to operate. The velocity saturation load in Figure 6 has a current limit of approximately 40 microamp. The switching characteristics are relatively insensitive to larger current limit values. Smaller current limits reduce power consumption but also reduce the noise margin and gain. This is due to the difficulty in obtaining true constant current in the load at extremely low current values, i.e. a few tens of microamps, as the result of substrate leakage currents.

The performance of the two types of loads are summarised in the table below:—

|  | Resistive pull-up | Velocity-saturation pull-up |
|---|---|---|
| Power dissipation (µW) (at VDD=1.0V) | 50 | 40 |
| Output voltage swing (V) (fanout=1) | 0.42 | 0.56 |
| Noise margin (mV) (high/low) | 60/110 | 250/150 |
| Switching-point gain | 1.3 | 3.0 |

## Claims

1. A gallium arsenide logic element having a non-linear pull-up load, said load comprising a gallium arsenide channel region disposed between first and second electrodes, the load being a two electrode device, characterised in that the load comprises a planar structure formed of a mesa (11) of active material disposed on a semi-insulating substrate (12) and that the saturation current of the load is determined by the spacing between the electrodes and the mesa thickness.

2. An element as claimed in claim 1, characterised in that the mesa height is between 0.5 and 1.5 microns.

3. An element as claimed in claim 1 or 2, characterised in that the mesa material is doped to a level of 0.5 to $1.0 \times 10^{17}$/cc.

4. An element as claimed in any one of claims 1 to 3, characterised in that the logic element includes an enhancement mode field effect transistor.

5. An integrated circuit including a plurality of logic elements as claimed in any one of the preceding claims.

6. A high speed data transmission system incorporating a plurality of integrated circuits as claimed in claim 5.

## Patentansprüche

1. Logischer Galliumarsenid-Schaltkreis mit einer nichtlinearen Pull-up-Lastimpedanz, welche einen Gallium-arsenid-Kanal-Bereich zwischen einer ersten und einer zweiten Elektrode enthält und ein Zweielektroden-Bauelement ist dadurch gekennzeichnet, daß die Lastimpedanz eine Planarstruktur enthält, die aus einem Mesa (11) aus aktivem Material auf einen halbisolierenden Substrat (12) gebildet ist, und daß der Sättigungsstrom durch den Abstand der Elektroden der Lastimpedanz und die Dicke des Mesas festgelegt ist.

2. Logischer Galliumarsenid-Schaltkreis nach Anspruch 1, dadurch gekennzeichnet, daß die Dicke des Mesas 0,5 bis 1,5 µm beträgt.

3. Logischer Galliumarsenid-Schaltkreis nach Anspruch 1 oder 2, dadurch gekennzeichnet, daß das Material des Mesas auf ein Niveau von 0,5 bis $1,0 \times 10^{17}$ cm$^{-3}$ dotiert ist.

4. Logischer Galliumarsenid-Schaltkreis nach einem der Ansprüche 1 bis 3, dadurch gekennzeichnet, daß der logische Schaltkreis einen Feldeffekttransistor des Anreicherungstyps enthält.

5. Integrierte Schaltung, gekennzeichnet durch eine Mehrzahl von logischen Schaltkreisen nach einem der Ansprüche 1 bis 4.

6. Hochgeschwindigkeits-Übertragungssystem, gekennzeichnet, durch eine Mehrzahl von integrierten Schaltungen nach Anspruch 5.

## Revendications

1. Elément logique en arséniure de gallium comportant une charge de polarisation an niveau haut non-linéaire, ladite charge comprenant une région de canal de arséniure de gallium disposée entre une première et une seconde électrode, la charge étant un dispositif à deux électrodes, caractérisé en ce que la charge comprend une structure plane formée d'une mesa (11) en matière active disposée sur un substrat semi-isolant (12), et en ce que le courant de saturation de la charge est déterminé par l'espacement entre les électrodes et l'épaisseur de la mesa.

2. Elément tel que revendiqué dans la revendication 1, caractérisé en ce que la hauteur de la mesa est comprise entre 0,5 et 1,5 micron.

3. Elément tel que revendiqué dans la revendication 1 ou 2, caractérisé en ce que le matériau de la mesa est dopé au niveau de 0,5 à $1,0 \times 10^{17}$ at/cm$^3$.

4. Elément tel que revendiqué dans l'une quelconque des revendications 1 à 3, caractérisé en ce que l'élément logique comprend un transistor à effet de champ à mode d'enrichissement.

5. Un circuit intégré comprenant une pluralité d'éléments logiques tels que revendiqués dans l'une quelconque des revendications précédentes.

6. Un système de transmission de données à grande vitesse comportant une pluralité de circuits intégrés tels que revendiqués dans la revendication 5.

Fig.1.

Fig.2.

Fig.3.

$$I_{sat} = n_0 - e - v_{sat} \cdot (t - z)$$

CURRENT

$v_{knee} \propto W$

Fig.4.

VOLTAGE

Fig.5.

Fig.6.